# EUROPEAN PATENT APPLICATION

(11) **EP 2 629 002 A2**
(43) Date of publication of application: **21.08.2013**
(21) Application number: 12184209.0
(22) Date of filing: 13.09.2012
(51) Int. Cl.: F21V 7/22, F21V 9/16, H01L 25/075, H01L 33/00, F21K 99/00, H01L 33/50, F21Y 101/02

(54) **Lighting apparatus**

(30) Priority: 16.02.2012 JP 2012032138
(71) Applicant: Toshiba Lighting & Technology Corporation, Yokosuka-shi Kanagawa 237-8510 (JP)
(72) Inventor: Matsunaga, Yoshiyuki, Kanagawa, 237-8510 (JP); Tamai, Hiroki, Kanagawa, 237-8510 (JP); Higuchi, Kazunari, Kanagawa, 237-8510 (JP)
(74) Representative: Bokinge, Ole

(57) **Abstract**

According to an exemplary embodiment, a lighting apparatus includes a light source (20, 62, 40) that includes a light emitting element (30, 42), and a member (14, 16, 64) which is irradiated with light emitted from the light source (20, 62, 40) and which is formed of resin having absorptivity of 15% or less in a wavelength in which intensity is 10% of a peak intensity, at a wavelength side that is shorter than an intensity peak of a spectrum of blue light emitted from the light source (20, 62, 40).

## Description

### FIELD

Embodiments described herein relate generally to a lighting apparatus.

### BACKGROUND

There is a lighting apparatus which includes a light emitting element such as a light emitting diode, and a wavelength conversion portion containing a phosphor.

According to such a lighting apparatus, compared to an incandescent lamp, a fluorescent lamp or the like using a filament of the related art, electric power consumption can be reduced and service life can also be made longer.

### DESCRIPTION OF THE DRAWINGS

FIG. 1 is a schematic perspective view that illustrates a lighting apparatus according to an exemplary embodiment.
FIG. 2 is a partial schematic cross-sectional view of a lighting apparatus illustrated in FIG. 1.
FIG. 3 is an absorption spectrum diagram of a resin that is used for a reflection portion of the exemplary embodiment.
FIG. 4 is an absorption spectrum diagram of a resin that is used for a reflection portion of a comparative example.
FIG. 5 is a photograph that illustrates an external appearance of a reflection portion after a lighting test of a lighting apparatus of a comparative example.
FIG. 6 is a photograph that illustrates an external appearance of a light source after the lighting test of the lighting apparatus of the comparative example.
FIG. 7 is a partial enlarged photograph of a peeling piece illustrated in FIG. 6.
FIGS. 8A to 8D are enlarged SEM (Scanning Electron Microscope) photographs of a part of the peeling piece illustrated in FIGS. 6 and 7.
FIGS. 9A to 9D are graphs that illustrate a result of a composition analysis of an interface between an electrode pad and a wavelength conversion layer.
FIG. 10 is a conceptual diagram that illustrates a mechanism of degradation of the reflection portion, the electrode pad or the like.
FIG. 11 is a cross-sectional view of a lighting apparatus of another embodiment.
FIG. 12 is a perspective exploded view of a lighting apparatus of another embodiment.
FIGS. 13A and 13B are partially enlarged perspective views of a lighting apparatus of another embodiment.
FIG. 14 is a schematic cross-sectional view of a lighting apparatus of still another embodiment.
FIG. 15 is a schematic cross-sectional view of a lighting apparatus of still another embodiment.
FIG. 16 is a schematic cross-sectional view of a lighting apparatus of still another embodiment.
FIG. 17A is a top view of a lighting apparatus of still another embodiment, and FIG. 17B is a partial cross-sectional view along line A-A' illustrated in FIG. 17A.

### DETAILED DESCRIPTION

According to an aspect, there is provided a lighting apparatus which includes a light source having a light emitting element, and a member to which light emitted from the light source is irradiated and which is formed of a resin that has absorptivity of 15% or less in a wavelength having intensity 10% of the peak intensity at a short wavelength side compared to the peak intensity of a spectrum of blue light emitted from the light source.

Hereinafter, an exemplary embodiment will be described with reference to the drawings. In addition, in the respective drawings, the same components are denoted by the same reference numerals and the detailed descriptions thereof will be suitably omitted.

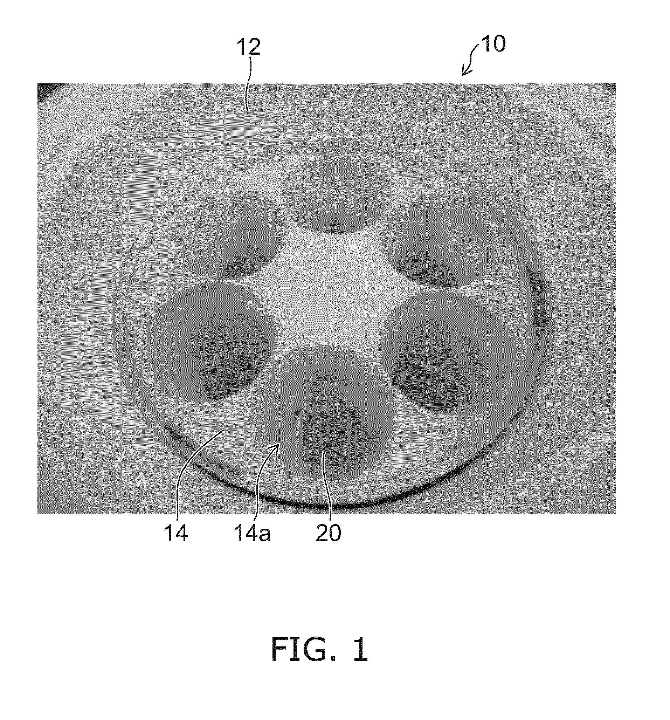

FIG. 1 is a schematic perspective view that illustrates a lighting apparatus according to the exemplary embodiment. That is, FIG. 1 is a perspective view in which the lighting apparatus 10 is viewed from a side of a light emitting surface.

The lighting apparatus 10 includes a main body portion 12, a reflection portion 14, and a light source 20. The reflection portion 14 is accommodated in the frame-shaped main body portion 12. The reflection portion 14 is provided with a plurality of concave portions 14a. Light sources 20 are each provided inside the respective concave portions 14a.

In addition, the lighting apparatus illustrated in FIG. 1 is merely an example, and only one each of the concave portion 14a and the light source 2 may be provided.

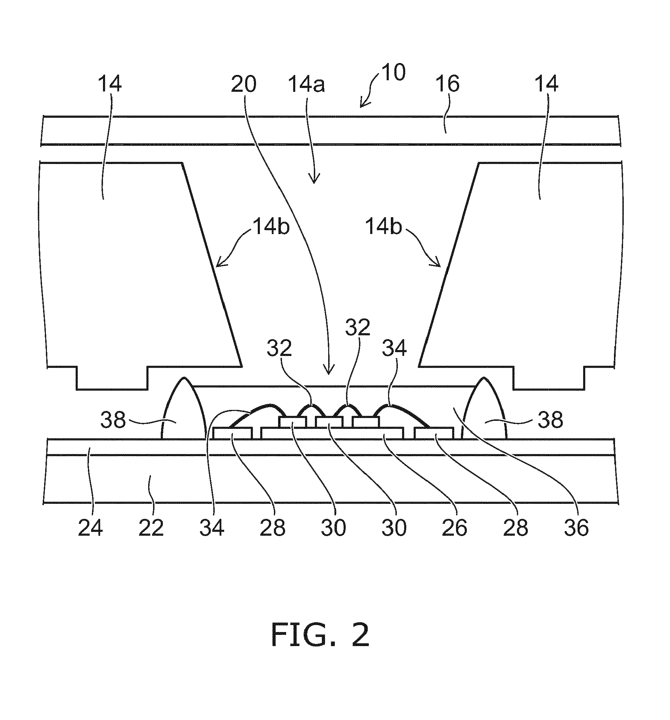

FIG. 2 is a partially schematic cross-sectional view of the lighting apparatus 10 illustrated in FIG. 1.

That is, FIG. 2 is a longitudinal sectional view in the vicinity of one concave portion 14a of the reflection portion 14 of the lighting apparatus 10.

A transparent cover 16 is provided above the reflection portion 14. In addition, FIG. 1 illustrates a state where the transparent cover 16 is removed.

The reflection portion 14 and the transparent cover 16 can be formed of a resin. Moreover, in the exemplary embodiment, if a resin is used as a material of a portion such as the reflection portion 14 and the transparent 16 on which light from the light source 20 hits, a resin is used in which absorptivity of light in a predetermined wavelength range is equal to or less than a predetermined value. This will be described later in detail.

The light source 20 is provided below the concave portion 14a of the reflection portion 14. The light source 20 has a metallic support substrate 22 and an insulating layer 24 that covers the surface thereof. A mounting pad 26 and an electrode pad 28 are each formed over the insulating layer 24. A plurality of light emitting elements 30 is mounted on the mounting pad 26. Such light emitting elements 30 are, for example, connected in series using a metal wire 32, and are connected to both electrode pads 28 using a wire 34. It is possible to make the light emitting elements 30 shine by causing the electric current to flow between the pair of electrode pads 28.

As the light emitting element 30, for example, a light emitting diode (LED) can be adopted. When, for example, using a gallium nitride (GaN)-based compound semiconductor as a material of an active layer, it is possible to obtain a short-wavelength light having a wavelength of 500 nanometers or less. However, the material of the active layer is not limited to the gallium nitride-base compound semiconductor.

Furthermore, as the light emitting element 30, in addition to the light emitting diode, for example, it is possible to use an organic light emitting diode (OLED), an inorganic electroluminescence light emitting element, an organic electroluminescence light emitting element, other electroluminescence type light emitting elements or the like.

Silver (Ag) or an alloy containing silver is provided on the surfaces of the mounting pad 26 and the electrode pad 28. Silver has high reflectivity to a short-wavelength of blue light or the like. Accordingly, by providing silver or silver alloy on the surfaces of the mounting pad 26 and the electrode pad 28, it is possible to reflect light emitted from the light emitting element 30 at high reflectivity to take the light to the outside.

The light emitting element 30 and the wires 32 and 34 are covered by a wavelength conversion layer 36. The wavelength conversion layer 36 has, for example, a structure in which the phosphor is dispersed in resin. The wavelength conversion layer 36 is surrounded by a frame 38 formed therearound. As resin constituting the wavelength conversion layer 36, for example, a silicone-based resin can be used. Furthermore, as a material of the frame 38, for example, a silicone-based resin can be used. If the silicone-based resin is used, even when light of a short-wavelength such as blue light or ultraviolet light is emitted from the light emitting element 30, the degradation can be suppressed.

The phosphor included in the wavelength conversion layer 36 absorbs light emitted from the light emitting element 30 and emits light of another wavelength. For example, when blue light of a wavelength of 450 nanometers to 500 nanometers is emitted from the light emitting element 30, it is possible to convert blue light into yellow light by the phosphor.

Thus, white light can be obtained if converting a part of blue light emitted from the light emitting element 30 into yellow light and mixing the yellow light with the blue light emitted to the outside without being converted. However, light taken from the lighting apparatus of the exemplary embodiment is not limited to white light.

In this manner, light such as white light emitted from the light source 20 can be taken to the outside from the concave portion 14a of the reflection portion 14 via the transparent cover 16. Furthermore, light emitted obliquely from the light source 20 is reflected by the reflection surface 14b serving as the inner wall surface of the concave portion 14a of the reflection portion 14 and can be taken to the outside via the transparent cover 16.

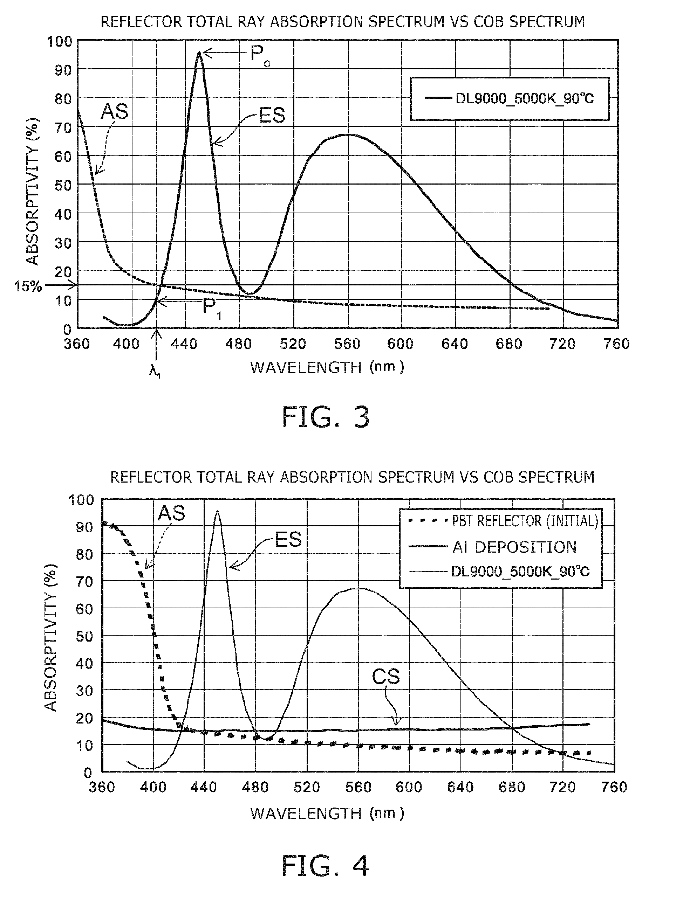

FIG. 3 is a graph that illustrates an absorption spectrum of resin used in the reflection portion 14 of the lighting apparatus of the exemplary embodiment.

In Fig. 3, a horizontal axis thereof indicates a wavelength (nanometer) and a vertical axis thereof indicates absorptivity (percentage). Herein, together with an absorption spectrum AS of resin, a light emitting spectrum ES of light emitted from the light source 20 are illustrated. In addition, the vertical axis of the light emitting spectrum ES is an arbitrary unit.

Herein, reflectivity is really measured, and in a relation formula of reflectivity + absorptivity + transmissivity = 1, absorptivity is calculated from reflectivity measured by setting transmissivity to 0.

Furthermore, liquid crystal polymer (LCP) is used as resin. When examining the absorption spectrum AS of rein, the absorptivity is low at the long wavelength side, but the absorptivity rapidly rises in a region of a wavelength shorter than about the wavelength of 400 nanometers.

Meanwhile, when examining the light emitting spectrum ES of the light source 20, there is a peak of blue light in wavelength of about 450 nanometers, and there is a broad peak of yellow light in the wavelength of about 560 nanometers. In a wavelength λ₁ of the short wavelength side compared to the intensity peak of blue light of the light emitting spectrum ES, intensity P₁ drops up to 10% of peak intensity P₀. When examining the absorption spectrum AS of resin, the absorptivity in the wavelength λ₁ is 15%. That is, the reflectivity of resin in the wavelength λ₁ is measured to 85%, and the absorptivity from the relation formula is calculated to 15%.

In the present embodiment, in this manner, resin is used in which the absorptivity in the wavelength λ₁, in which intensity of blue light emitted from the light source 20 drops to 10% of the peak, is equal to or less than 15% (the reflectivity is 85% or more).

That is, in the exemplary embodiment, when using resin as a material of a portion to which light from the light source 20 is directly or indirectly irradiated, resin satisfying conditions mentioned below is used. That is, resin is used in which absorptivity in the wavelength in which intensity is 10% of the peak intensity is equal to or less than 15% (reflectivity is equal to or greater than 85%) at the short wavelength side further than the intensity peak of the spectrum of blue light emitted from the light source 20.

FIG. 4 is a graph that illustrates the absorption spectrum AS of resin used in the reflection portion of the lighting apparatus of a comparative example.

Furthermore, FIG. 4 also illustrates the spectrum ES of light emitted from the light source.

Furthermore, FIG. 4 also illustrates an absorption spectrum CS of resin on which aluminum is deposited.

Herein, a PBT containing bromine, which is heated and maintained without being exposed to light, is used as resin.

In the comparative example, the absorptivity at the short wavelength side, in which the intensity is 10% of the peak intensity, is about 20% at the short wavelength side further than the intensity peak of the spectrum of blue light emitted from the light source.

In addition, when examining the absorption spectrum CS of resin on which aluminum is deposited as a reference example, although the absorptivity is higher than the PBT containing bromine of the initial state at the long wavelength side further than the wavelength of 440 nanometers, the absorptivity does not rapidly rise in the wavelength that is equal to or less than that, and the absorptivity thereof is also low at the short wavelength side.

It is understood from FIGS. 3 and 4 that resin of the exemplary embodiment has the absorptivity of 15% at the short wavelength side in which intensity of blue light emitted from the light source is 10% of the peak intensity, but the absorptivity is higher than 15% in a comparative example.

When resin used in the lighting apparatus absorbs light of short wavelength emitted from the light source, decomposition and denaturation may occur. Moreover, when decomposition and denaturation of resin occur, the absorptivity drops or impurities are desorbed, which may affect the components of the lighting apparatus. Thus, in order to prevent degradation of resin from the initial state, there is a need to reduce the absorptivity of light emitted from the light source as possible.

The inventors found that degradation of resin can be suppressed by setting the absorptivity of resin at the short wavelength side, in which the intensity of blue light emitted from the light source is 10% of the peak intensity, to 15% or less.

In this manner, reliability of the lighting apparatus can be improved.

As a specific example of resin usable in the exemplary embodiment, it is possible to adopt, for example, an LCP (Liquid Crystal Polymer), PEI (polyetherimide), PEEK (polyetheretherketone), PPE (Polyphenyleneether), PPO (Polyphenyleneoxide), PBT (Poly Buthylene Terephthalete), PET (Poly Ethylene Terephthalate), PA (Polyamide), PPA (Polyphtal amide), PAR (Polyarylate), PC(Polycarbonate) or the like. Moreover, a complex resin containing the resin mentioned above of 50 weight% or more may be adopted. When using the complex resin, it is easy to design heat resistance and incombustibility.

In such resin, the absorptivity in the short wavelength region can be controlled by adjusting the composition, the kind of the additive, and the amount thereof. That is, by adjusting the composition of resin and the additive, it is possible to set the absorptivity of resin at the short wavelength side, in which intensity of blue light emitted from the light source is 10% of the peak intensity, to 15% or less.

The inventors made a lighting apparatus using the reflection portion 14 that is formed of resin having the absorption spectrum AS illustrated in FIG. 3.

Furthermore, as a comparative example, the reflection portion of the lighting apparatus having the structure as illustrated in FIGS. 1 and 2 was formed of the PBT added as bromine (Br) illustrated in FIG. 4. Moreover, the lighting apparatuses of the exemplary embodiment and the comparative example were each subjected to a lighting test at an output of 57 watts.

In the lighting apparatus of the comparative example, illumination gradually dropped after the lighting test is started, and the non-lighting state was obtained at substantially 4000 hours. Meanwhile, in the lighting apparatus of the present exemplary embodiment, there was no meaningful change in illumination after 4000 hours elapse.

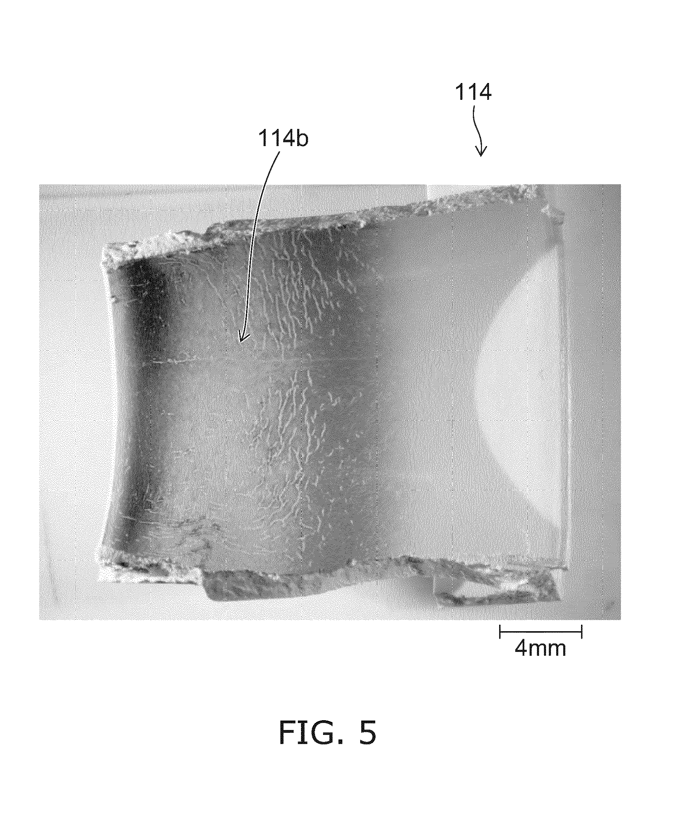

FIG. 5 is a photograph that illustrates an external appearance of the reflection portion 114 after the lighting test of the lighting apparatus of the comparative example.

That is, FIG. 5 illustrates a surface of the reflection surface 114b of the reflection portion 114. In addition, a reflection surface 114b corresponds to the reflection surface 14b in FIG. 2.

Although the reflection surface 114b was white before the lighting test, the reflection surface 114b after the lighting test turns black and cracking is partially generated. That is, it is understood that the surface of the PBT added with bromine (Br) makes denaturation. It is understood that reflectivity of the reflection surface 114b drops due to the darkening and the crack, and the illumination of the lighting apparatus drops.

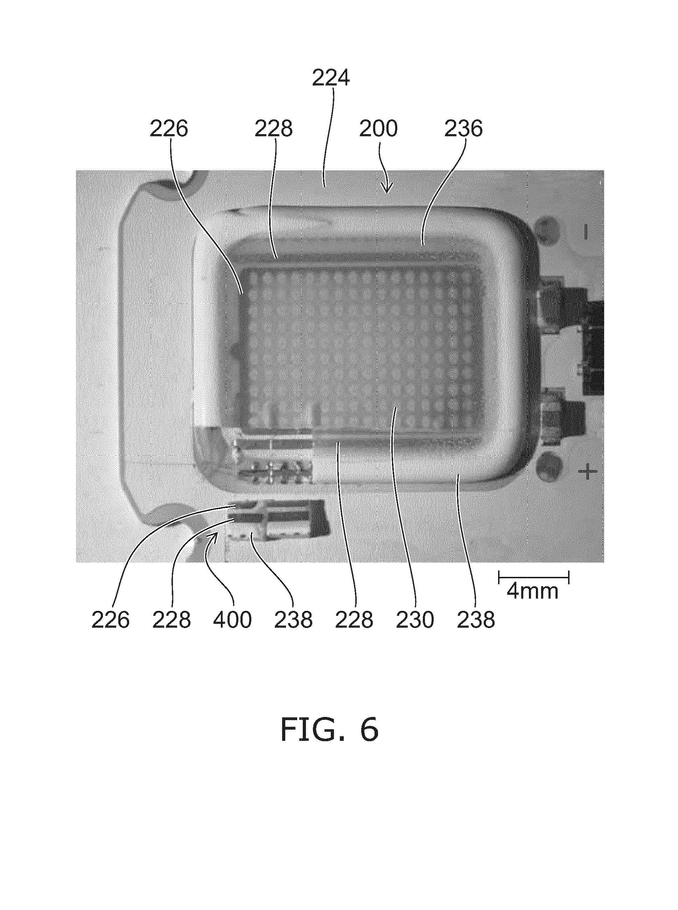

Next, FIG. 6 is a photograph that illustrates an external appearance of a light source 200 after the lighting test of the lighting apparatus of the comparative example. The light source 200 corresponds to the light source 20 illustrated in FIGS. 1 and 2.

The light source 200 is formed on a white insulating layer 224 (corresponding to the insulating layer 24), and a light emitting element 230 (corresponding to the light emitting element 30) sealed in a wavelength conversion layer 236 (corresponding to the wavelength conversion layer 36) is provided in a frame 238 (corresponding to the frame 38). The light emitting element 230 is mounted on a mounting pad 226 (corresponding to the mounting pad 26). Furthermore, electrode pads 228 (corresponding to the electrode pad 28) are provided at both sides of the mounting pad 226 and are connected to the light emitting element 230 using a wire. The surfaces of the mounting pad 226 and the electrode pad 228 are covered by silver.

A left end portion and a right portion facing the mounting pad 226 illustrated in FIG. 6 are each darkened. Furthermore, the electrode pads 228 provided above and below the mounting pad 226 are also darkened. In the comparative example, it is understood that reflectivity of light drops and illumination drops due to the darkening.

After checking a portion of the electrode pad 228 in detail, it was understood that a darkened surface layer of the electrode pad 228 is peeled and a bonding portion of the wire is also peeled. That is, it was proved that the wire enters a disconnection state, and a non-lighting state is obtained.

FIG. 6 illustrates that a peeled piece 400 peeled is placed inside out in a left lower part of the light source 200.

The peeling piece 400 has a surface layer of the mounting pad 226, a surface layer of the electrode pad 228, the wavelength conversion layer 236 sealing therearound, and a part of the frame 238.

In this manner, in darkened portions of the mounting pad 226 and the electrode pad 228, the surfaces thereof is altered and are simply peeled.

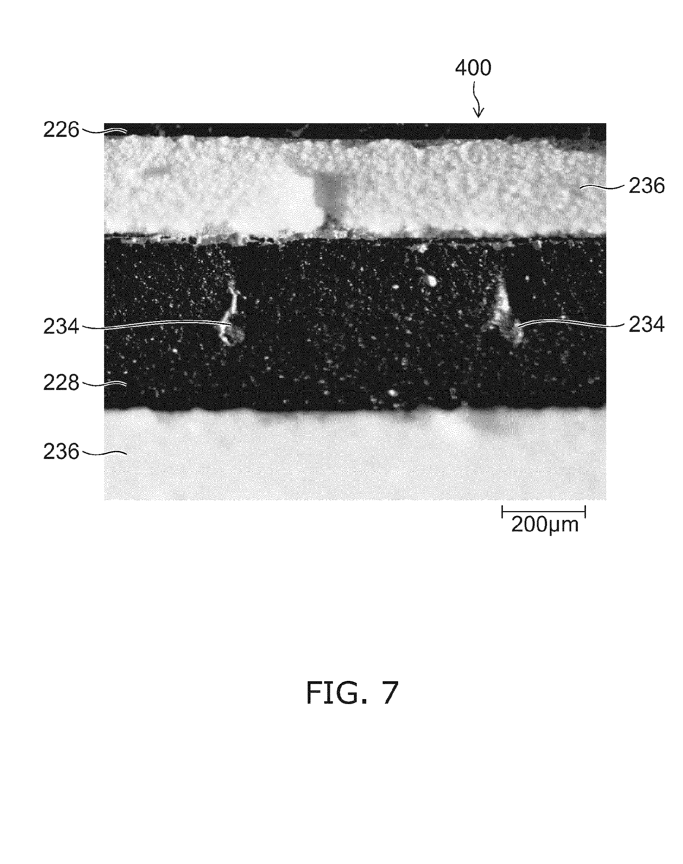

FIG. 7 is a partial enlarged photograph of the peeling piece 400 illustrated in FIG. 6.

The surface layer of the peeled electrode pad 228 becomes black and exhibits an external appearance condensed in a particle shape. Furthermore, the wire 234 is also peeled from the remaining portion (a portion remained over the insulating layer 224) of the electrode pad 228. That is, it is understood that sliver of the electrode pad 228 is altered.

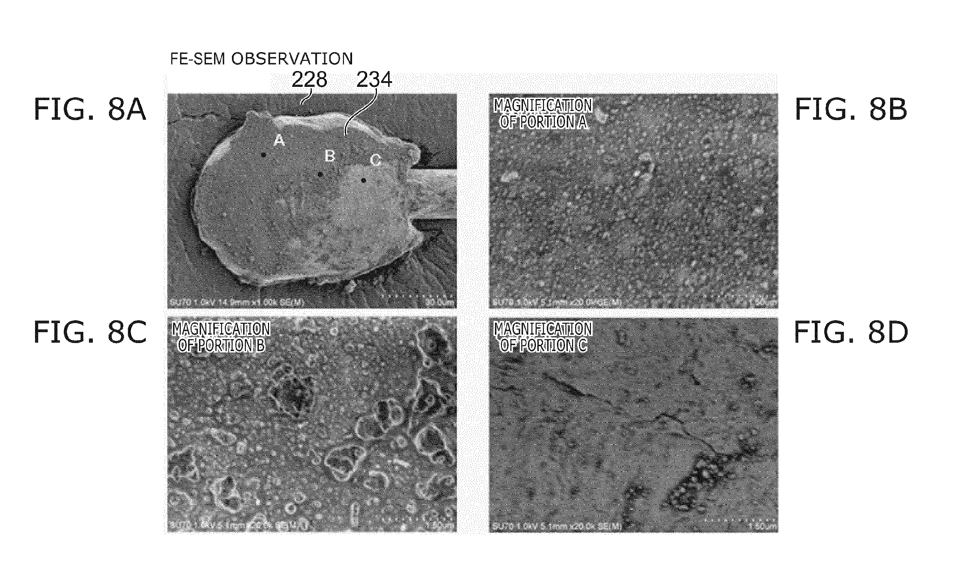

FIGS. 8A to 8D are enlarged SEM (Scanning Electron Microscope) photographs of a part of the peeling piece 400 shown in FIGS. 6 and 7.

That is, FIG. 8A illustrates a leading end of a bonding portion of the wire 234 peeled together with the electrode pad 228. Furthermore, FIG. 8B is an enlarged photograph of an A portion of FIG. 8A, FIG. 8C is an enlarged photograph of a B portion of FIG. 8A, and FIG. 8D is an enlarged photograph of a C portion of FIG. 8A.

Although a material of the wire 234 is gold (Au), the surface thereof becomes alloyed by being bonded to a silver layer of the electrode pad 228. Moreover, a structure of a condensed particle shape is also seen on the surface of the peeled wire 234. As a result of EPMA (Electron Probe Micro Analysis) analysis, it was understood that the structure of the particle shape contains silver.

That is, it is understood that denaturation of silver also occurs on a bonding interface between the wire 234 and the electrode pad 228.

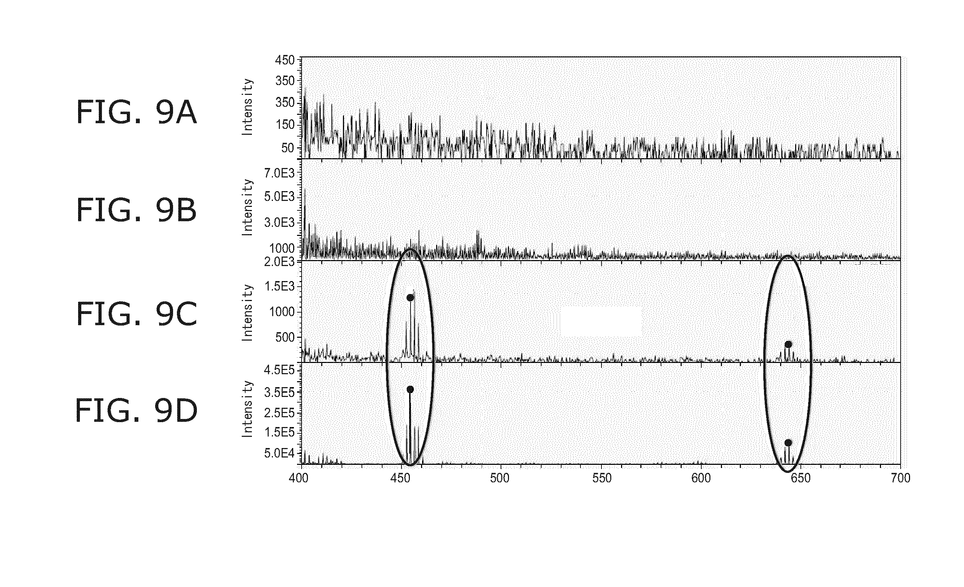

FIGS. 9A to 9D are graphs that illustrate a result of a composition analysis of an interface between of the electrode pad and the wavelength conversion layer.

Herein, as in the peeling piece 400 illustrated in FIGS. 6 to 8D, the wavelength conversion layer on the electrode pad was peeled, and the surface of the peeling pad and the surface of the electrode pad remained at the substrate side each were subjected to a composition analysis using SIMS (Secondary Ion Mass Spectroscopy) in a position of the electrode pad.

FIG. 9A illustrates a result of the composition analysis of the surface of the electrode pad 28 side of the wavelength conversion side 36 that is peeled from the light source 20 of the lighting apparatus according to the exemplary embodiment.

FIG. 9B illustrates a result of the composition analysis of the surface of the electrode pad 28 remained at the insulating layer 24 (see FIG. 2) side by peeling the wavelength conversion layer 36 from the light source 20 of the lighting apparatus according to the exemplary embodiment.

FIG. 9C illustrates a result of the composition analysis of the surface of the electrode pad 28 side of the peeling piece 400 peeled from the light source 20 of the lighting apparatus of the comparative example.

FIG. 9D illustrates a result of the composition analysis of the surface of the electrode pad 228 remained at the insulating layer 224 (see FIG. 6) side by peeling the peeling piece 400 from the light source 20 of the lighting apparatus of the comparative example.

In the comparative example, even at the peeling piece 400 side (FIG. 9C) and even at the insulating layer 224 side (FIG. 9D), in the range of a horizontal axis n/z of 450 to 460, a peak of Ag₂Br₃ is seen, and in the range of the horizontal axis n/z of 640 to 650, a peak of Ag₃Br₄ is seen. Furthermore, as a consequence of analysis, a peak of AgBr and a peak of AgBr₂ were also confirmed.

On the contrary, in the lighting apparatus of the exemplary embodiment, even at the side (FIG. 9A) of the peeling piece, and even at the insulating layer 24 side (FIG. 9B), a meaningful peak is not seen.

From the analysis result, it is understood that, in the comparative example, at the time of the lighting test, bromine or the compound containing bromine is desorbed from the reflection portion 114, bromine or the compound containing bromine reaches the surface of the electrode pad 228 and reacts with silver, and silver bromide is formed. Moreover, in the process when silver bromide is formed in this manner, as illustrated in FIGS. 6, 7 or the like, it is considered that the surfaces of the electrode pad 228 and the mounting pad 226 become dark and condense in a particle shape and are peeled, and the disconnection of the wire 234 is generated.

Furthermore, it is considered that bromine or the compound containing bromine is desorbed from the reflection portion 114, thus as illustrated in FIG. 5, the reflection surface 114b of the reflection portion 114 becomes dark, and cracking is generated.

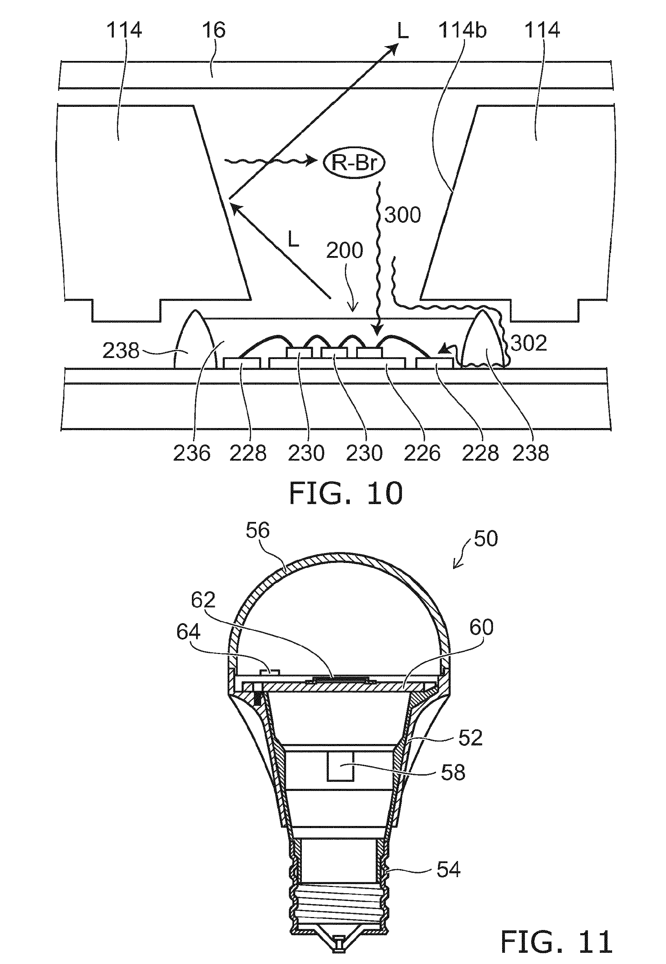

FIG. 10 is a conceptual diagram that illustrates a mechanism of degradation of the reflection portion, the electrode pad or the like.

Light L including components of the short wavelength is emitted from the light source 200, and a part thereof is reflected by the reflection surface 114b of the reflection portion 114 and is taken to the outside. However, when the absorptivity of the reflection portion 114 is not low, light of the short wavelength is absorbed to the reflection portion 114. Since light of the short wavelength has high energy, the light decomposes and alters the resin components of the reflection portion 114. When the PBT added with bromine absorbs light of the short wavelength the decomposition and the denaturation occur, and bromine or the compound thereof is desorbed from the reflection portion 114.

As a consequence of the decomposition and the denaturation, FIG. 10 illustrates that, as an example, an organic matter R-Br containing bromine is desorbed from the reflection portion 114. As indicated by an arrow 300, the desorbed organic matter R-Br reaches the mounting pad 226 and the electrode pad 228 via the wavelength conversion layer 236, reacts with silver of the surface thereof, and causes darkening, cohesion, peeling or the like. Furthermore, as an entry course of the desorbed R-Br, for example, as indicated by an arrow 302, it is also possible to consider a course going though the frame 238 or an interface in the lower side of the frame 238.

Furthermore, it is also possible to consider that, before or after the organic matter R-Br reaches the mounting pad 226 and the electrode pad 228, the organic matter is decomposed by light of the short wavelength emitted from the light emitting element 230, and the more active bromine ion is formed.

In addition, although a situation of containing bromine was described as an example in the specific example mentioned above, the exemplary embodiments are not limited thereto. The reason is that, like bromine, a halogen or phosphorus other than bromine also reacts with silver, and causes darkening, cohesion, disconnection or the like.

According to the mechanism mentioned above, the irradiation of light and the rise of the temperature cause the decomposition and the denaturation of resin, and as a consequence, a halogen and phosphorus or the compound thereof is desorbed. Moreover, the desorbed halogen and phosphorus or the compound thereof react with silver of the electrode pad and the mounting pad, which causes the drop in illumination, disconnection of the wire or the like.

On the contrary, in the exemplary embodiment, when using resin in the portion on which light from the light source 20 hits, the absorptivity is controlled to a predetermined range.

Furthermore, in some cases, a halogen and phosphorus are added to improve incombustibility of resin. Moreover, in the lighting apparatus, since the temperature of the light source rises, resin requires a predetermined incombustibility. Thus, in the exemplary embodiment, it is possible to achieve a predetermined level of incombustibility by adjusting the composition of resin and other additives to control the absorptivity to a predetermined range while adding a halogen and phosphorus.

In regard to incombustibility, it is desirable to use some kinds of resin which has a grade of a V-1 grade or more in the UL 94 standard, that is, corresponding to some grades of V-1, V-0, 5VB, and 5VA.

FIGS. 11 to 13B are schematic views that illustrate a lighting apparatus according to another embodiment.

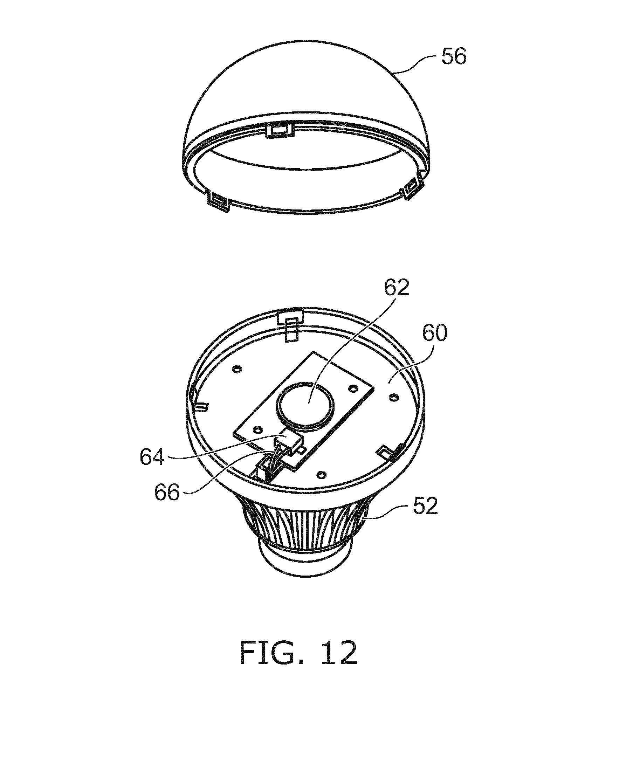

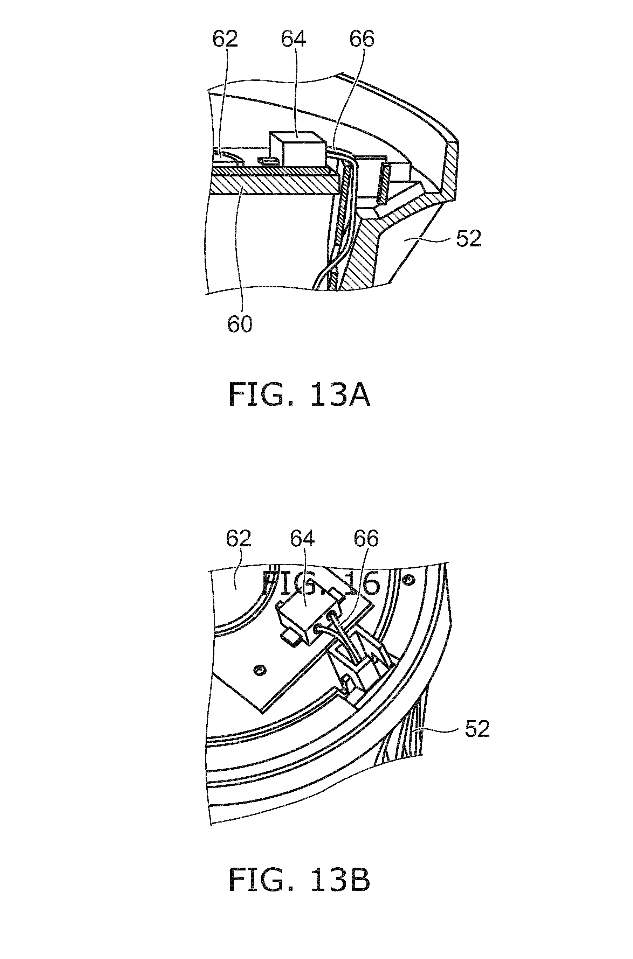

That is, FIG. 11 is a cross-sectional view of the lighting apparatus of the exemplary embodiment, FIG. 12 is a perspective exploded view thereof, and FIGS. 13A and 13B are partial enlarged perspective views thereof.

The lighting apparatus 50 of the exemplary embodiment is a so-called "electric bulb type" and can be used in an appliance which uses a filament type electric bulb of the related art as it is.

A metal cap portion 54 is provided in a base of a main body portion 52 and can be screwed into the lighting appliance instead of the electric bulb of the related art.

A transparent or semitransparent cover 56 is provided on the main body portion 52. A power source substrate 58 is accommodated inside the main body portion 52. Furthermore, an installation substrate 60 is fixed to the vicinity of the upper end of the main body portion 52, and a light source 62 is provided thereon. The light source 62 corresponds to the light source 20 in the specific example illustrated in FIGS. 1 and 2, and is provided with a mounting pad, an electrode pad, a light emitting element, a wavelength conversion layer, a wire or the like (none of the components are shown).

A connection member 64 is provided on the installation substrate 60. The connection member 64 is, for example, a connector, and connects a wiring 66 connected to the power source substrate 58 with the light source 62. The wiring 66 has a structure in which a core line of a conductor is covered by an insulator.

In the exemplary embodiment, for example, the coating or the like of the connection member 64 and the wiring 66 is formed of resin having absorptivity of 15% or less in a short wavelength side in which intensity of blue light emitted from the light source 62 is 10% of the peak intensity. In this manner, it is possible to prevent resin constituting the coating or the like of the connection member 64 and the wiring 66 from dropping in the reflectivity due to absorption of light of the short wavelength, decomposition and denaturation, or from generating darkening, cohesion, disconnection of the wiring due to desorption of the components of resin and reaction with silver of the mounting pad and the electrode pad provided in the light source 62.

As a consequence, it is possible to provide a lighting apparatus having high reliability.

In addition, the shape and the arrangement of the connection member 64 and the wiring 66 are not limited to the illustrated specific example. For example, the connection member 64 may be a "contact point connector" which is provided around the light source in a frame shape and is connected via a contact point.

In addition, in the exemplary embodiment, the members to be formed of resin, which has absorptivity limited to a predetermined range, are not limited to the reflection portion, the connection member, and the wiring. That is, the members may be directly or indirectly irradiated with light emitted from the light source. For example, the members correspond to the main body portion, the installation substrate, the transparent cover, and in addition, various elements provided in the lighting apparatus.

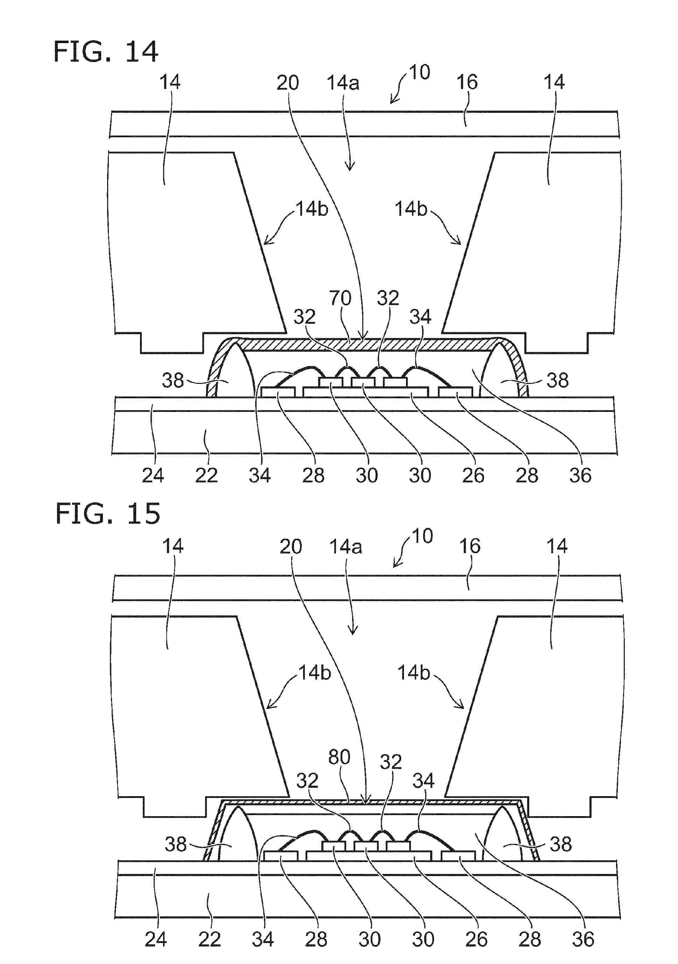

Figs. 14 to 16 are schematic cross-sectional views that illustrate a lighting apparatus according to still another embodiment.

In the lighting apparatus shown in FIG. 14, a diffusion restriction layer 70 is formed around the light source 20. The diffusion restriction layer 70 restricts that a halogen, phosphorus, the compound thereof (for example, R-Br illustrated in FIG. 10) or other resin components generated by the decomposition and the denaturation in the member such as the reflection portion 14 formed of resin is diffused to the light source 20 and enters therein. In this manner, even if a halogen, phosphorus and the compound containing these components is generated in the lighting apparatus, it is possible to prevent darkening, the cohesion, the disconnection or the like of the mounting pad, the electrode pad of the light source 20 or the like. Furthermore, by containing a halogen, phosphorus or the like, it is advantageous to use resin with the improved characteristics such as incombustibility.

The diffusion restriction layer 70 preferably has a material and a structure which have high transmissivity to light emitted from the light source 20 and are able to maintain a certain degree of airtightness. As a material of the diffusion restriction layer 70, an organic material, an inorganic material or the like can be used. The diffusion restriction layer 70 can be formed by applying, curing and drying a liquid organic material or inorganic material so as to cover the light source 20. In this case, as a raw material of the diffusion restriction layer 70, a water glass or the like can be used.

In addition, it is not required to necessarily form the diffusion restriction layer 70 so as to come into contact with the light source 20. That is, the diffusion restriction layer 70 may cover the periphery of the light source 20, and may prevent the components, which is desorbed from resin, from entering inside the light source 20. For this reason, for example, as in a filter 80 described in FIG. 15 later, the diffusion restriction layer 70 may be provided around the light source 20 while being separated from the light source 20.

Next, in the lighting apparatus shown in FIG. 15, a filter 80 is provided between the light source 20 and the reflection portion 14. The filter 80 has optical characteristics of selectively absorbing light of short wavelength side of lights that is emitted from the light source 20. That is, the filter 80 has optical characteristics of selectively absorbing light of the wavelength region in which absorptivity of resin used in the lighting apparatus rises.

For example, if resin having the absorption spectrum of the initial state of the PBT illustrated in FIG. 9 is used as the member of the lighting apparatus, it is desirable to absorb light of the wavelength side shorter than a wavelength of about 420 nanometers, in which absorptivity rises, using the filter 80. If doing so, it is possible to suppress light intensity absorbed in resin, and thus it is possible to suppress darkening, the decomposition, and the denaturation of resin as illustrated in FIG. 5, the occurrence of a halogen, phosphorus, the compound containing the components or the like. Furthermore, it is advantageous to use resin with improved characteristics such as incombustibility by adding a halogen, phosphorus or the like.

In addition, in the exemplary embodiment, as in the diffusion restriction layer 70 illustrated in FIG. 14, the filter 80 may be provided so as to come into contact with the light source 20.

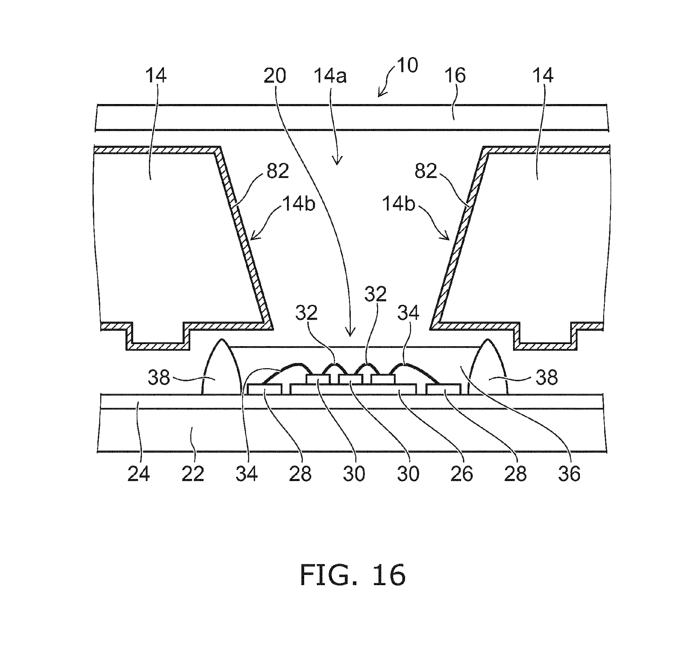

Next, in the lighting apparatus illustrated in FIG. 16, a filter 82 is provided on the surface of the reflection portion 14. As in the filter 80 illustrated in FIG. 15, the filter 82 selectively absorbs light of the short wavelength side of light being emitted from the light source 20. That is, the filter 82 has optical characteristics of selectively absorbing light of the wavelength region in which absorptivity of resin used in the lighting apparatus rises. In this manner, the same effect as the exemplary embodiment illustrated in FIG. 15 is obtained.

In addition, although FIG. 16 illustrates a specific example in which the filter 82 is provided to come into contact with the surface of the reflection portion 14, the exemplary embodiments are not limited thereto. That is, the filter 82 may be provided between the member formed of resin like the reflection member 14 and the light source 20.

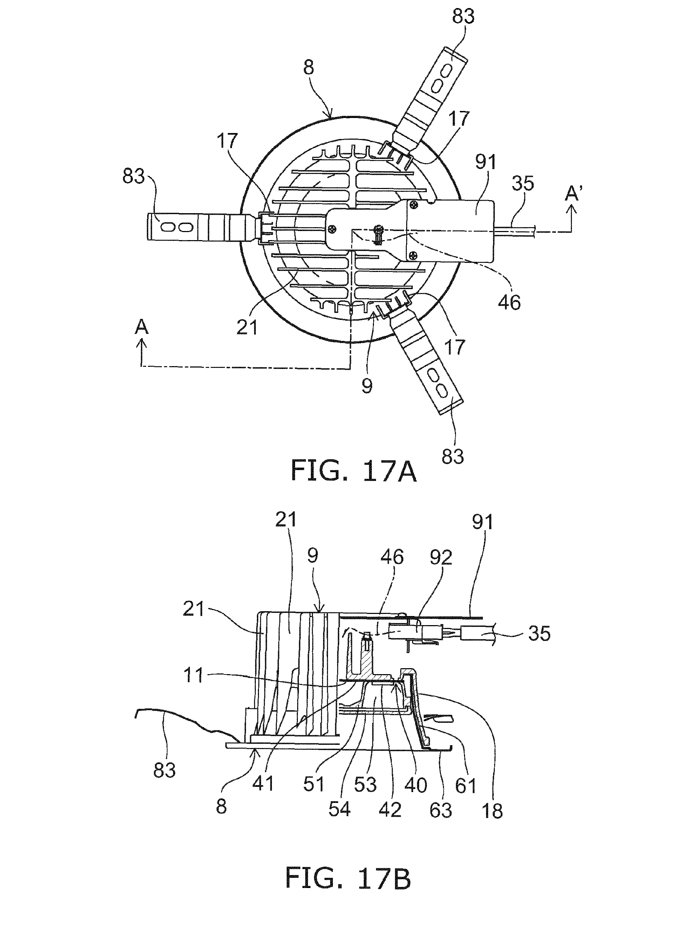

Next, FIG. 17A is a top view of a lighting apparatus of still another embodiment, and FIG. 17B corresponds to a partial cross-sectional view of an A-A' line direction in FIG. 17A.

The lighting apparatus of the exemplary embodiment mainly has a radiator 9, a light source 40 and a frame 8.

The radiator 9 is provided with a plurality of radiation fins 21. Furthermore, the radiator 9 has a cylindrical side wall portion 18. An outer wall of the side wall portion 18 is also provided with a plurality of radiation fins 21.

The light source 40 has a substrate 41, and an LED element 42 which is implemented on the substrate 41 and is covered by a wavelength conversion layer. A back surface of an opposite side of the implementation surface with the light emitting element 42 implemented thereon in the substrate 41 comes into contact with a substrate support surface 11 of the radiator 9.

The LED element 42 is implemented so that an emitting surface of light faces the opposite side of the implementation surface of the substrate 41. Furthermore, a connector (not shown) is also implemented on the implementation surface of the substrate 41. An electric cable 46 is connected to the connector.

The electric cable 46 is connected to a terminal block 92 illustrated in FIG. 17B. The terminal block 92 is attached to an attachment plate 91 which is screwed and fixed to the upper end of the radiation fin 21. The terminal block 92 is connected to an external power source (not shown) through an electric cable 35 which is led to the outside of the lighting apparatus.

A frame 60 functions as a clock decorative rim that covers an inner surface and a lower end portion of the side wall portion 18 of the radiator 9. Furthermore, the frame 60 also has a function of controlling a light distribution or shading of light that is emitted from the light source 40.

The frame 60 has a cylinder portion 61 which is superimposed on the inside of the side wall portion 18 of the radiator 9. The cylinder portion 61 surrounds a lower space of the light source 40. A lower end portion 63 bent to the outside of the cylinder portion 61 is provided in the lower end of the cylinder portion 61. The lower end portion 63 is formed in a ring shape and covers the lower end of the side wall portion 18 of the radiator 9.

As shown in FIG. 17B, a reflection plate 51 is provided in the inner space of the cylinder portion 61. The reflection plate 51 is formed with a plurality of light guide holes 53 as through holes.

The reflection plate 51 is superimposed on the substrate 41 of the light source 40 so as to expose the LED element 42 from the light guide hole 53. An inner wall surface of the light guide hole 53 functions as a reflection surface.

Furthermore, a light transmission cover 54 is provided in the inner space of the cylinder portion 61 so as to cover the reflection plate 51.

In the outer wall of the side wall portion 18 of the radiator 9, as shown in FIG. 17A, a plurality (for example, three) of installation spring attachment portions 17 is provided. One end portions of installation springs 83 serving as plate springs are inserted and fixed to the respective installation spring attachment portions 17.

Moreover, the lighting apparatus of the exemplary embodiment is attached to an implementation hole provided on a ceiling using elasticity of three installation springs 83. That is, the lighting apparatus of the exemplary embodiment is a down light type lighting apparatus.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A lighting apparatus comprising:
a light source (20, 62, 40) that includes a light emitting element (30, 42); and
a member (14, 16, 64) which is irradiated with light emitted from the light source (20, 62, 40) and which is formed of resin having absorptivity of 15% or less in a wavelength in which intensity is 10% of peak intensity, at a wavelength side that is shorter than an intensity peak of a spectrum of blue light emitted from the light source (20, 62, 40).

2. The apparatus according to claim 1, wherein light emitted from the light source (20, 62, 40) has a peak of intensity in a wavelength of 500 nanometers or less.

3. The apparatus according to claim 1 or 2, wherein the resin has incombustibility of V-1 or more in UL 94.

4. The apparatus according to any one of claims 1 to 3, wherein the member is a reflection portion (14) that reflects light emitted from the light source (20).

5. The apparatus according to any one of claims 1 to 3, wherein the member is a connection member (64) that connects the light source (62) with a power source.

6. The apparatus according to any one of claims 1 to 5, wherein the resin includes at least one of LCP (Liquid Crystal Polymer), PEI (polyetherimide), PEEK (polyetheretherketone), PPE (Polyphenyleneether), PPO (Polyphenyleneoxide), PBT (Poly Buthylene Terephthalete), PET (Poly Ethylene Terephthalate), PPA (Polyphtal amide), PAR (Polyarylate), PC (Polycarbonate), and PA(Polyamide).

7. The apparatus according to any one of claims 1 to 5, wherein the resin contains 50 weight % or more of PBT (Poly Buthylene Terephthalete).

8. The apparatus according to any one of claims 1 to 7, wherein the member (14, 16, 64) is formed of resin which has reflectivity of 85% or more in a wavelength in which intensity is 10% of the peak intensity, at a wavelength side that is shorter than the intensity peak of the spectrum of the blue light.

9. The apparatus according to any one of claims 1 to 8, further comprising:
a diffusion restriction layer (70) that is provided to cover the periphery of the light source (20) and suppress halogen and phosphorus from entering the light source (20).

10. The apparatus according to claim 9, wherein the diffusion restriction layer (70) is an organic material or an inorganic material which has permeability to light emitted from the light source (20) and airtightness.

11. The apparatus according to any one of claims 1 to 8, further comprising:
a filter (80) that is provided between the light source (20) and the member (14) and has optical characteristics of selectively absorbing light of a short wavelength side of light emitted from the light source (20).

12. The apparatus according to claim 11, wherein the filter (80) absorbs light of a wavelength side that is shorter than a wavelength of 420 nanometers.

13. The apparatus according to any one of claims 1 to 8, further comprising:
a filter (82) that is provided on a surface of the member (14) and has optical characteristics of selectively absorbing light of a short wavelength side of light emitted from the light source (20).

14. The apparatus according to claim 13, wherein the filter (82) absorbs light of a wavelength side that is shorter than a wavelength of 420 nanometers.

15. The apparatus according to any one of claims 1 to 14, wherein the light emitting element (30, 42) is an LED (Light Emitting Diode).
